# EUROPEAN PATENT SPECIFICATION

(11) **EP 2 195 398 B1**
(45) Date of publication and mention of the grant of the patent: **22.05.2013**
(21) Application number: 08836003.7
(22) Date of filing: 03.10.2008
(51) Int. Cl.: C09D 183/04, H01L 31/0216, C09D 183/05, C23C 18/12, H01L 21/312, H01L 21/02, H01L 21/316

(54) **METHOD OF FORMING A CERAMIC SILICON OXIDE TYPE COATING, METHOD OF PRODUCING AN INORGANIC BASE MATERIAL, AGENT FOR FORMING A CERAMIC SILICON OXIDE TYPE COATING, AND SEMICONDUCTOR DEVICE**
VERFAHREN ZUR FORMUNG EINER KERAMIK-SILICIUMOXID-BESCHICHTUNG, VERFAHREN ZUR HERSTELLUNG EINES ANORGANISCHEN BASISMATERIALS DAFÜR, MITTEL ZUR FORMUNG EINER KERAMIK-SILICIUMOXID-BESCHICHTUNG UND HALBLEITERVORRICHTUNG
PROCÉDÉ DE FORMATION D'UN REVÊTEMENT DU TYPE OXYDE DE SILICIUM CÉRAMIQUE, PROCÉDÉ DE PRODUCTION D'UN MATÉRIAU DE BASE INORGANIQUE, AGENT DE FORMATION D'UN REVÊTEMENT DU TYPE OXYDE DE SILICIUM CÉRAMIQUE, ET DISPOSITIF SEMICONDUCTEUR

(30) Priority: 05.10.2007 JP 2007262513
(43) Date of publication of application: 16.06.2010
(73) Proprietor: Dow Corning Toray Co., Ltd., Tokyo, 100-0004 (JP); Dow Corning Corporation, Midland, Michigan 48686-0994 (US)
(72) Inventor: HARIMOTO, Yukinari, Ichihara-shi Chiba 299-0108 (JP); MICHINO, Tetsuyuki, Ashigarakami-gun Kanagawa 258-0112 (JP); KATSOULIS, Elias, Dimitris, Midland, Michigan 48642 (US); KUSHIBIKI, Nobuo, Fujisawa-shi Kanagawa 251-0875 (JP); SUTO, Michitaka, Ichihara-shi Chiba 299-0108 (JP)
(74) Representative: Polypatent
(86) International application number: PCT/JP2008/068509
(87) International publication number: WO 2009/044938

(56) References cited:
- EP-A- 0 410 564
- EP-A- 0 579 456
- WO-A-2007/046560
- US-B1- 6 218 020

## Description

### Technical Field

The present invention relates to a method of forming a ceramic silicon oxide type coating, a method of producing an inorganic base material that has a ceramic silicon oxide type coating on the surface, an agent for forming a coating that can be converted into a ceramic silicon oxide type coating, and a semiconductor device in which at least a semiconductor layer is formed on a ceramic silicon oxide type coating on an inorganic base material.

### Background Art

The basic properties required of the substrate used for the formation of, for example, an electrode layer, semiconductor layer, light-emitting layer, and so forth, in a semiconductor device such as, for example, a solar battery and the like, are, inter alia, the absence of deformation, deterioration, or strain when exposed to the high temperatures in the process of forming the electrode layer, semiconductor layer, light-emitting layer, and so forth; high planarity; absence of alterations, for example, rust, caused by atmospheric moisture; absence of defects, such as pinholes, in the semiconductor film; and freedom from warpage, peeling, and cracking.
Accompanying the trend in recent years toward lighter, smaller, and more diverse electronic devices and semiconductor devices, and also based on economic considerations, attention is being directed to thin film semiconductor elements and devices, such as thin film solar batteries, thin film transistors (TFTs) for reflection-type liquid crystal display devices, thin film electroluminescent display elements, and so forth. With regard in particular to the solar batteries used in satellites, weight reduction is one of the most critical issues and there is demand for high-performance thin film solar batteries. The substrates used here include metal substrates, glass substrates, and ceramic substrates, and while these have surfaces that are apparently planar, close inspection reveals the presence of microscopic asperities (for example, projections, elevations, depressions, trenches, pores). The formation of a thin electrode layer, thin semiconductor layer, thin light-emitting layer, and so forth, on such a surface yields a non-uniform thin layer and cannot avoid the generation of defect sites.

Moreover, accompanying the increasing level of integration and the increasing number of layers in these thin film semiconductor devices, the semiconductor devices have become quite complex and step heights on the semiconductor device surface have become quite substantial. A passivation film is formed on the semiconductor device surface in order to planarize the topography on the semiconductor device surface or in order to protect the semiconductor device from mechanical damage, chemical damage, damage from static, ionic contamination, nonionic contamination, contamination by radiation, and so forth. In addition, accompanying the increasing number of electrical circuit layers in semiconductor devices, an interlayer dielectric film may be formed for the purposes of electrical insulation between conductors and planarization.
Silicon oxide type films are typically used for the interlayer dielectric films and passivation films that are formed on semiconductor device surfaces. Chemical vapor deposition (CVD) and spin coating are examples of the methods used to form silicon oxide type films on semiconductor device surfaces; the use of the inorganic spin-on-glass (SOG) disclosed in Patent Reference 1 (JP H06-042478 B) and the use of organic SOGs are examples of the methods used to form silicon oxide type films on semiconductor device surfaces by spin coating.

However, the silicon oxide type coatings formed by inorganic SOGs undergo cracking when their film thickness exceeds 0.3 µm, which has necessitated multiple coatings in order to bury, that is, planarize, the step heights on semiconductor devices that have step heights of 1 µm or more. Moreover, the coating itself has a poor planarization performance in the case of inorganic SOGs, which has necessitated an etching-based planarization step after formation of the coating.
The silicon oxide type coatings formed by organic SOGs, on the other hand, have the capacity to form crack-free silica type coatings at thicknesses of less than 2 µm by a single application. However, as with the inorganic SOGs, the coating itself has a poor planarization performance, which has necessitated an etching-based planarization step after formation of the coating. There have also been other problems, such as a high hygroscopicity due to the large number of residual silanol groups and alkoxy groups in the silicon oxide type coating, residual alkoxy group-induced carbon poisoning during oxygen plasma treatment, and inferior electrical reliability when used as an interlayer dielectric agent.

As a consequence of the preceding, methods have been disclosed to improve upon the problems associated with silicon oxide type coatings formed by inorganic SOGs and organic SOGs. For example, in the method disclosed in JP H06-042477 B (Patent Reference 2), a hydrogensilsesquioxane resin solution is coated on an electronic device; the solvent is evaporated to form a hydrogensilsesquioxane resin coating; and a ceramic-like silicon oxide type coating is then formed by heating to 150 to 1000°C. In the method disclosed in JP H03-183675 A (Patent Reference 3), a hydrogensilsesquioxane resin solution is coated on a substrate; the solvent is evaporated to form a hydrogensilsesquioxane resin coating; and a ceramic-like silicon oxide type coating is then formed by heating to 500 to 1000°C.

The same method is also described in particular in paragraph [0061] and Figure 11(b) of JP 2005-026534 A (Patent Reference 4). The hydrogensilsesquioxane resin itself is melted by heating in this method, which as a consequence provides an excellent capacity to planarize the step heights on the semiconductor device surface and renders an etching process unnecessary. In addition, since the siloxane structure of the hydrogensilsesquioxane resin does not have organic groups, this method has the advantage of avoiding the issue of carbon poisoning during oxygen plasma treatments.

However, it is not easy to form a silicon oxide type coating having a film thickness of 0.8 µm or more without cracking using the methods disclosed in Patent References 2 to 4 for forming silicon oxide type films. As a consequence, a problem with these methods has been their inability to completely planarize step heights of 0.8 µm or more on the surface of electronic devices and particularly semiconductor devices. In addition, when the formation of a thick-film silicon oxide type coating is pursued using these methods, cracks and pinholes can be produced in the silicon oxide type coating, which has resulted in the problem of a substantial reduction in electronic device reliability and particularly in semiconductor device reliability.

Methods that solve these problems are disclosed in JP 2007-111645 A (Patent Reference 5) and WO 2007/046560 A2 (Patent Reference 6). A cyclic dihydrogenpolysiloxane or a branched hydrogenpolysiloxane is coated on an inorganic substrate and the hydrogenpolysiloxane is converted to silica by, for example, heating, to form a silica type glass thin layer on the inorganic substrate. However, both cyclic dihydrogenpolysiloxane and branched hydrogenpolysiloxane are generally synthesized from dihydrogendichlorosilane. Dihydrogendichlorosilane has a boiling point of 8°C, is strongly flammable, and has a very high hydrolyzability and as result requires that extensive precautions with regard to handling be implemented during cyclic dihydrogenpolysiloxane synthesis or branched hydrogenpolysiloxane synthesis. In addition, because both cyclic dihydrogenpolysiloxane and branched hydrogenpolysiloxane contain the [H₂SiO_{2/2}] unit, extensive precautions are required during production and storage. This is due to the fact that a dehydrogenative condensation reaction proceeds vigorously when condensation reaction-active impurities are present.

### Summary of the Invention

As a result of intensive research in order to develop a method of forming a ceramic silicon oxide type coating and a method of producing an inorganic base material having a silicon oxide type coating, wherein these methods would be free of the problems cited above, the present inventors discovered that a coating comprising an organohydrogensiloxane·hydrogensiloxane copolymer may be formed on an inorganic base material and then heated at high temperatures in an inert gas or an oxygen gas-containing inert gas (oxygen gas less than 20 volume%) until conversion to silicon oxide.

An object of the present invention is to provide a method of forming a ceramic silicon oxide type coating, a method of producing an inorganic base material having a ceramic silicon oxide type coating, an agent for forming a coating that can be converted into a ceramic silicon oxide type coating, and a semiconductor device that uses an inorganic substrate that has a ceramic silicon oxide type coating, in each instance which is free of the problems cited above. That is, an object of the present invention is to provide a method of forming a ceramic silicon oxide type coating that uses a hydrogensiloxane type polymer which does not require the implementation of extensive precautions during production and storage, and that can planarize an inorganic base material and in particular that can planarize an inorganic substrate whose surface exhibits microscopic asperities, wherein the ceramic silicon oxide type coating thereby formed is free of cracks and pinholes even at a film thickness in excess of 1.0 µm, substantially does not contain hygroscopicity-inducing silanol groups, and substantially does not contain carbon poisoning-inducing alkoxy groups.
Another object of the present invention is to provide a method of producing an inorganic base material that has said ceramic silicon oxide type coating.
Yet another object of the present invention is to provide an agent that forms a coating that can be converted into said ceramic silicon oxide type coating.
A further object of the present invention is to provide a semiconductor device that uses the aforesaid inorganic base material, that is highly reliable and very durable, and that can take the form of a thin film.

The present invention relates to
"[1] A method of forming a ceramic silicon oxide type coating, comprising
   forming a coating comprising an organohydrogensiloxane-hydrogensiloxane copolymer represented by siloxane unit formula (1):

   (HRSiO_{2/2})ₙ(HSiO_{3/2})ₘ (1)

   (in the formula, R is a monovalent hydrocarbyl group selected from the group consisting of C ₁₋₁₀ alkyl group and C₆₋₁₀ aryl group, **n** is a number with an average value of 0.01 ≤ **n** ≤ 0.80, and **n** + **m** = 1) on the surface of an inorganic base material; and
   then heating the coated inorganic base material to a high temperature in an inert gas or an oxygen gas-containing inert gas (oxygen gas less than 20 volume%) to convert the coating into a ceramic silicon oxide type coating.
   [1-1] A method of forming a ceramic silicon oxide type coating according to [1], wherein **n** is a number with an average value of 0.05 ≤ **n** ≤ 0.50 in the siloxane unit formula (1).
   [1-2] A method of forming a ceramic silicon oxide type coating according to [1] or [1-1], wherein R is methyl group, phenyl group, or methyl group and phenyl group in the siloxane unit formula (1).
[2] The method of forming a ceramic silicon oxide type coating according to [1], wherein the inert gas is nitrogen gas.
   [2-1] The method of forming a ceramic silicon oxide type coating according to [1-1] or [1-2], wherein the inert gas is nitrogen gas.
[3] The method of forming a ceramic silicon oxide type coating according to [1] or [2], wherein the heating temperature is 300 to 600°C.
   [3-1] The method of forming a ceramic silicon oxide type coating according to [1-1], [1-2] or [2-1], wherein the heating temperature is 300 to 600°C."

The present invention further relates to
"[4] A method of producing an inorganic base material having a ceramic silicon oxide type coating on the surface, comprising
   forming a coating comprising an organohydrogensiloxane·hydrogensiloxane copolymer represented by siloxane unit formula (1):

   (HRSiO_{2/2})ₙ(HSiO_{3/2})ₘ (1)

   (in the formula, R is a monovalent hydrocarbyl group selected from the group consisting of C₁₋₁₀ alkyl group and C₆₋₁₀ aryl group, n is a number with an average value of 0.01 ≤ **n** ≤ 0.80, and **n** + **m** = 1) on the surface of an inorganic base material; and
   then heating the coated inorganic base material to a high temperature in an inert gas or an oxygen gas-containing inert gas (oxygen gas less than 20 volume%) to convert the coating into a ceramic silicon oxide type coating.
   [4-1] A method of producing an inorganic base material having a ceramic silicon oxide type coating on the surface according to [4], wherein **n** is a number with an average value of 0.05 ≤ **n** ≤ 0.50 in the siloxane unit formula (1).
   [4-2] A method of producing an inorganic base material having a ceramic silicon oxide type coating on the surface according to [4] or [4-1], wherein R is methyl group, phenyl group, or methyl group and phenyl group.
   [4-3] A method of producing an inorganic base material having a ceramic silicon oxide type coating on the surface according to [4], [4-1] or [4-2], wherein the inert gas is nitrogen gas.
   [4-4] A method of producing an inorganic base material having a ceramic silicon oxide type coating on the surface according to [4], [4-1], [4-2] or [4-3], wherein the heating temperature is 300 to 600°C.
[5] The method of producing an inorganic base material according to [4], wherein the inorganic base material is a metal substrate, ceramic substrate, glass substrate, quartz substrate, or electronic device.
   [5-1] The method of producing an inorganic base material according to [4-1], [4-2], [4-3], or [4-4], wherein the inorganic base material is a metal substrate, ceramic substrate, glass substrate, quartz substrate, or electronic device.
[6] The method of producing an inorganic base material according to [5], wherein the metal substrate is a thin and flexible metal plate.
   [6-1] The method of producing an inorganic base material according to [5-1], wherein the metal substrate is a thin and flexible metal plate.
[7] The method of producing an inorganic base material according to [6], wherein the thin and flexible metal plate is a stainless steel foil.
   [7-1] The method of producing an inorganic base material according to [6-1], wherein the thin and flexible metal plate is a stainless steel foil."

The present invention additionally relates to
"[8] An agent for forming a ceramic silicon oxide type coating, that comprises (A) an organohydrogensiloxane-hydrogensiloxane copolymer represented by siloxane unit formula (1):

   (HRSiO_{2/2})ₙ(HSiO_{3/2})ₘ (1)

   (in the formula, R is a monovalent hydrocarbyl group selected from the group consisting of C₁₋₁₀ alkyl group and C₆₋₁₀ aryl group, **n** is a number with an average value of 0.01 ≤ **n** ≤ 0.80, and **n** + **m** = 1), or comprises component (A) and (B) an organic solvent in a quantity required for the dissolution or dilution of component (A), and can be converted to a ceramic silicon oxide type coating by heating to a high temperature in an inert gas or an oxygen gas-containing inert gas (oxygen gas less than 20 volume%).
[9] The agent for forming a ceramic silicon oxide type coating according to [8], wherein **n** in siloxane unit formula (1) is a number with an average value of 0.05 ≤ **n** ≤ 0.50.
[10] The agent for forming a ceramic silicon oxide type coating according to [8] or [9], wherein R in siloxane unit formula (1) is methyl, phenyl, or methyl and phenyl.
   [10-1] The agent for forming a ceramic silicon oxide type coating according to [8], [9] or [10], wherein the inert gas is nitrogen gas.
   [10-2] The agent for forming a ceramic silicon oxide type coating according to [8], [9], [10] or [10-1], wherein the heating temperature is 300 to 600°C."

The present invention further relates to
"[11] A method for producing a semiconductor device comprising:
   forming a coating comprising an organohydrogensiloxane-hydrogensiloxane copolymer represented by siloxane unit formula (1):

      (HRSiO_{2/2})ₙ(HSiO_{3/2})ₘ (1)

      (in the formula, R is a monovalent hydrocarbyl group selected from the group consisting of C₁₋₁₀ alkyl group and C₆₋₁₀ aryl group, **n** is a number with an average value of 0.01 ≤ **n** ≤ 0.80, and **n** + **m** = 1) on the surface of a metal substrate; and
   then heating the coated inorganic base material to a high temperature in an inert gas or an oxygen gas-containing inert gas (oxygen gas less than 20 volume%) to convert the coating into a ceramic silicon oxide type coating; and then forming a semiconductor layer on the ceramic silicon oxide type coating of the metal substrate..
[12] The method according to [11], wherein the metal substrate is stainless steel foil; the semiconductor layer is a silicon semiconductor thin layer or a compound semiconductor thin layer; and the semiconductor device is a thin film solar battery.

According to the method of the present invention for forming a ceramic silicon oxide type coating using the organohydrogensiloxane-hydrogensiloxane copolymer, it is possible to form a ceramic silicon oxide type coating on an inorganic base material with taking less extensive precautions during formation and storage phases in comparison with the conventional method.
According to the method of the present invention for producing an inorganic base material using the organohydrogensiloxane·hydrogensiloxane copolymer, it is possible to produce an inorganic base material having a ceramic silicon oxide type coating on the surface with taking less extensive precautions during formation and storage phases in comparison with the conventional method.
The method of the present invention for forming a ceramic silicon oxide type coating and the ceramic silicon oxide type coating of the present invention have the ability to planarize an inorganic base material, in particular have the ability to planarize the surface of an inorganic substrate that exhibits microscopic asperities, and specifically have the ability to planarize even surfaces that exhibit a surface roughness of 10 nm or more. In addition, they have the ability to planarize an inorganic base material and particularly the surface of an electronic device that presents height differences and specifically have the ability to planarize even surfaces that have a step height of 1.0 µm or more.
The ceramic silicon oxide type coating that is formed is free of cracks and pinholes even at film thicknesses in excess of 1.0 µm, substantially does not contain hygroscopicity-inducing silanol groups, and substantially does not contain carbon poisoning-inducing alkoxy groups.

The agent of the present invention for forming a ceramic silicon oxide type coating, when coated on an inorganic base material and heated to a high temperature in an inert gas or oxygen gas-containing inert gas (oxygen gas less than 20 volume%), converts to a ceramic silicon oxide type coating; this ceramic silicon oxide type coating is free of cracks and pinholes even at film thicknesses substantially in excess of 1.0 µm, substantially does not contain hygroscopicity-inducing silanol groups, and substantially does not contain carbon poisoning-inducing alkoxy groups.
The semiconductor device of the present invention, because it comprises at least a semiconductor layer formed on the ceramic silicon oxide type coating on a metal substrate, exhibits an excellent reliability and durability and can take the form of a thin film.

### Brief Description of the Drawing

Figure 1 is a cross-sectional diagram of stainless steel foil bearing a ceramic silicon oxide type coating on one side, in accordance with Practical Example 1 of the present invention.
Figure 2 is a cross-sectional diagram of a thin glass plate bearing a ceramic silicon oxide type coating on both sides, in accordance with Practical Example 3 of the present invention.
Figure 3 is a cross-sectional diagram of a semiconductor device that is an embodiment of the present invention; this semiconductor device has a semiconductor layer on the silicon oxide type coating of stainless steel foil that bears a ceramic silicon oxide type coating on one side.
Figure 4 is a cross-sectional diagram of the thin film compound semiconductor solar battery cell of Practical Example 4 of the present invention.

### Description of the Reference Symbols

1: ceramic silicon oxide type coating
2: stainless steel foil
3: thin glass plate
4: semiconductor thin layer
5a: Mo back-side electrode thin layer
5b: ITO transparent electrode thin layer
6: high-resistance CdS buffer thin layer
7: CIGS-type light-absorbing thin layer comprising CuInGaSe₂
8: ZnO semi-insulating thin layer

### Best Mode for Carrying Out the Invention

The method of the present invention for forming a ceramic silicon oxide type coating and the method of the present invention for producing an inorganic base material having a ceramic silicon oxide type coating on the surface, are each characterized by
forming a coating comprising an organohydrogensiloxane-hydrogensiloxane copolymer represented by siloxane unit formula (1):

(HRSiO_{2/2})ₙ(HSiO_{3/2})ₘ (1)

(in the formula, R is a monovalent hydrocarbyl group selected from the group consisting of C₁₋₁₀ alkyl group and C₆₋₁₀ aryl group, **n** is a number with an average value of 0.01 ≤ **n ≤** 0.80, and **n** + **m** = 1) on the surface of an inorganic base material; and
then heating the coated inorganic base material to a high temperature in an inert gas or an oxygen gas-containing inert gas (oxygen gas less than 20 volume%) to convert the coating into a ceramic silicon oxide type coating.

The organohydrogensiloxane-hydrogensiloxanecopolymer represented by siloxane unit formula (1) is a copolymer comprising the (HRSiO_{2/2}) unit and (HSiO_{3/2}) unit, and converts to a ceramic silicon oxide type coating when placed under high temperatures, i.e., 300 to 600°C, in an inert gas or an oxygen gas-containing inert gas (oxygen gas less than 20 volume%).

R in siloxane unit formula (1) is a monovalent hydrocarbyl group selected from the group consisting of C₁₋₁₀ alkyl group and C₆₋₁₀ aryl group. This alkyl can be exemplified by methyl, ethyl, propyl, butyl, hexyl, and octyl. The aryl can be exemplified by phenyl, tolyl, and xylyl. From the standpoints of ease of production and ease of conversion into the ceramic silicon oxide, R is preferably methyl, phenyl, or methyl and phenyl.

**n** in siloxane unit formula (1) is on average 0.01 ≤ **n** ≤ 0.80 wherein **n** + **m** = 1. When **n** is less than 0.01, gelation readily occurs during synthesis of the copolymer represented by siloxane unit formula (1), and, even when gelation does not occur during synthesis, a tendency is seen wherein this copolymer undergoes an increase in molecular weight during storage in solution form. In addition, cracking is prone to occur in the coating during conversion into the ceramic silicon oxide type coating by heating at high temperatures. **n** is preferably at least 0.05 based on a consideration of the stability during and after this synthesis and based on a consideration of the resistance to cracking during conversion into the ceramic silicon oxide type coating. When **n** exceeds 0.80, the ceramic silicon oxide type coating does not have an acceptably high hardness and, due to the relatively high organic group content in the copolymer, a satisfactory etching resistance is not obtained in any oxygen plasma treatment process carried out after formation of the coating. **n** is preferably no greater than 0.50 based on a consideration of the hardness of this ceramic silicon oxide type coating and its etching resistance. Thus, based on the preceding considerations, **n** preferably has an average value of 0.05 ≤ **n** ≤ 0.50.

The molecular structure of this copolymer varies as a function of the numerical value of **n** and may be, for example, a branched chain structure, branched structure, network structure or three-dimensional structure. The degree of branching increases as the numerical value of **n** trends to 0.01, resulting in a three-dimensional structure. The degree of branching declines as the numerical value of **n** trends to 0.80, resulting in a branched chain structure. The weight-average molecular weight of this copolymer is not particularly limited, but is preferably at least 1,000 and no more than 100,000 in order, through melt flow during heating, to planarize the inorganic base material, particularly asperities on a metal substrate, ceramic substrate, or glass substrate, and asperities and step heights on an electronic device or semiconductor device.
This copolymer is a liquid or solid at ambient temperature. The viscosity of the liquid copolymer is not particularly limited. The softening point of the solid copolymer is not particularly limited, but is preferably no more than 400°C from the standpoint of the melt fluidity during heating.

The method of producing the organohydrogensiloxane-hydrogensiloxane copolymer represented by siloxane unit formula (1) is not particularly limited as long as a copolymer comprising the (HRSiO_{2/2}) unit and (HSiO_{3/2}) unit can be produced. For example, production can be readily carried out by subjecting **n** moles of (a) an organohydrogendichlorosilane represented by the formula HRSiX₂ (R in the formula is an organic group selected from the group consisting of C₁₋₁₀ alkyl group and C₆₋₁₀ aryl group, X is a halogen atom or an alkoxy group) to cohydrolysis/condensation with **m** moles of (b) HSiX₃ (X in the formula is a halogen atom or an alkoxy group) at a molar ratio such that 0.01 ≤ **n** ≤ 0.80 and **n** + **m** = 1 in a mixed liquid of nonpolar organic solvent, hydrochloric acid, and ionic surfactant and by then subjecting the nonpolar organic solvent layer containing the produced organohydrogensiloxane·hydrogensiloxane copolymer to washing with water, drying, and distillative removal of the volatile components, such as the nonpolar organic solvent or alcohol originating from the alkoxy group.

This R is preferably only methyl group, only phenyl group, or methyl group and phenyl group. The nonpolar organic solvent used here can be exemplified by aromatic hydrocarbon type organic solvents and aliphatic hydrocarbon type organic solvents. The aromatic hydrocarbon type organic solvents can be exemplified by toluene and xylene, while the aliphatic hydrocarbon type organic solvents can be exemplified by hexane, heptane, octane, and cyclohexane.
The hydrochloric acid used here is preferably concentrated hydrochloric acid and more preferably is hydrochloric acid having a hydrogen chloride content of 15 to 37 mass%. The hydrogen chloride content preferably is in the range of 10 to 80 mass% with reference to the nonpolar organic solvent.

The ionic surfactant used here inhibits gelation that could occur due to the rapid hydrolysis/condensation and solo condensation of the hydrogentrichlorosilane and promotes cohydrolysis/condensation with the organohydrogendichlorosilane. This ionic surfactant encompasses anionic surfactants, cationic surfactants, and amphoteric surfactants.

The anionic surfactant can be exemplified by alkali metal salts of aliphatic hydrocarbon sulfonic acids, for example, alkali metal salts of C₆₋₂₀ alkylsulfonic acids and alkali metal salts of C₆₋₂₀ alkenesulfonic acids; alkali metal salts of alkylbenzenesulfonic acids; aliphatic hydrocarbon sulfonic acids, for example, C₆₋₂₀ alkylsulfonic acids and C₆₋₂₀ alkenesulfonic acids; alkylbenzenesulfonic acids; alkali metal salts of alkyl sulfate esters; and alkali metal salts of higher fatty acids. The alkali metals referenced here are preferably sodium and potassium.

The cationic surfactant can be exemplified by quaternary ammonium salts, for example, tetramethylammonium chloride, benzyltributylammonium chloride, cetyltrimethylammonium chloride, and tetrabutylammonium chloride; and by alkylamine hydrochlorides, for example, dodecylamine hydrochloride.

The amphoteric surfactant can be exemplified by 2-alkyl-N-carboxymethyl-N-hydroxyethylimidazolinium betaine, sodium undecylcarboxymethoxyethylcarboxymethylimidazolinium betaine, sodium undecylhydroxyethylimidazolinium betaine, undecyl-N-hydroxyethyl-N-carboxymethylimidazolinium betaine, alkyldiaminoethylethylglycine hydrochloride, stearyldihydroxyethyl betaine, stearyldimethylaminoacetic acid betaine, and sodium stearyldimethyl betaine.

The ionic surfactant is used preferably at 0.01 to 50 mass% and more preferably at 0.1 to 1.0 mass%, in each case with reference to the water in the hydrochloric acid.

The cohydrolysis/condensation reaction is run, for example, by the dropwise addition of a nonpolar organic solvent solution containing the organohydrogendichlorosilane and hydrogentrichlorosilane into a mixture of the nonpolar organic solvent, hydrochloric acid, and ionic surfactant, and stirring. In this case, stirring is preferably also carried out during the dropwise addition.

When the thus produced organohydrogensiloxane-hydrogensiloxane copolymer represented by siloxane unit formula (1) is a liquid at ambient temperature, it may be supplied without dilution by an organic solvent to coating on the surface of the inorganic base material. However, this copolymer is preferably diluted with an organic solvent when it exhibits a viscosity that does not permit the application of a thin coating. When the organohydrogensiloxane-hydrogensiloxane copolymer represented by siloxane unit formula (1) is a solid at ambient temperature, it can be supplied to coating on the surface of the inorganic base material without dissolution in an organic solvent in those instances where it can be liquefied at a temperature below the thermal decomposition temperature. However, the copolymer is preferably dissolved in an organic solvent when it exhibits a melt viscosity that does not permit the execution of a thin coating. Dissolution in an organic solvent is required when the copolymer is a solid at ambient temperature and has a softening point that is higher than the temperature at which decomposition starts.

The agent of the present invention for forming a ceramic silicon oxide type coating characteristically comprises (A) an organohydrogensiloxane-hydrogensiloxane copolymer represented by siloxane unit formula (1):

(HRSiO_{2/2})ₙ(HSiO_{3/2})ₘ (1)

(in the formula, R is a monovalent hydrocarbyl group selected from the group consisting of C₁₋₁₀ alkyl group and C₆₋₁₀ aryl group, **n** is a number with an average value of 0.01 ≤ **n ≤** 0.80, and **n** + **m** = 1), or comprises component (A) and (B) an organic solvent in the quantity required for the dissolution or dilution of component (A), and can be converted into a ceramic silicon oxide type coating by heating to a high temperature in an inert gas or an oxygen gas-containing inert gas (oxygen gas less than 20 volume%). As described above, component (B) is unnecessary when component (A) itself can be thinly coated on the surface of the inorganic base material. Dissolution or dilution by component (B) becomes necessary when component (A) is itself not capable of being thinly coated on the surface of the inorganic base material.
Preferable R and n in siloxane unit formula (1) is the same as written in paragraph [0022], the molecular structure, properties and method for the written preparation of the organohydrogensiloxane·hydrogensiloxane copolymer is the same as written in paragraphs [0023] and [0024], the preferable gas is the same as written in paragraph [0046], and the preferable temperature and time s the same as written in paragraph [0047].

The organic solvent as component (B) is not particularly limited as long as it does not have any deleterious effects and is able to uniformly dissolve or dilute the organohydrogensiloxane·hydrogensiloxane copolymer as component (A). Such organic solvents can be specifically exemplified by alcohols such as methanol, ethanol, and so forth; cellosolve type solvents such as methyl cellosolve, i.e., ethyleneglycol monomethyl ether, ethyl cellosolve, i.e., ethyleneglycol monoethyl ether; ketone solvents such as methyl ethyl ketone, methyl isobutyl ketone; ester solvents such as butyl acetate, isoamyl acetate, methyl cellosolve acetate, i.e., ethyleneglycol methyl ether acetate, ethyl cellosolve acetate, i.e., ethyleneglycol ethyl ether acetate; and silicone type solvents such as chain-form dimethylsiloxane oligomers (for example, 1,1,1,3,3,3-hexamethyldisiloxane, 1,1,3,3-tetramethyldisiloxane), cyclic dimethylsiloxane oligomers (for example, 1,1,3,3,5,5,7,7-octamethyltetracyclosiloxane, 1,3,5,7-tetramethyltetracyclosiloxane), alkylsilane compounds (for example, tetramethylsilane, dimethyldiethylsilane). Other examples are mixtures of two or more of the preceding organic solvents.

The agent of the present invention for forming a ceramic silicon oxide type coating can contain, insofar as there are no negative effects on component (A), optional components in addition to components (A) and (B). A dehydrogenative condensation reaction catalyst is an example of such an optional component. Specific examples are platinum compound catalysts such as chloroplatinic acid, platinum/alkene complexes, platinum/β-diketone complexes, platinum/divinyltetramethyldisiloxane complexes, alcohol-modified chloroplatinic acid solutions; tetraalkoxytitanium catalysts; organotin compound catalysts; and acid catalysts such as hydrochloric acid, acetic acid. Since these catalysts accelerate the dehydrogenative condensation reaction of component (A), they must be added in small-to-trace amounts immediately before coating.

Finely divided inorganic powders are another optional component. Examples of finely divided inorganic powders are inorganic microspherical particles, inorganic microtubes, and inorganic microplates, wherein colloidal silica and colloidal alumina are representative examples. The co-use of a finely divided inorganic powder with component (A) can improve the durability and properties (for example, strength, thermal expansion coefficient) of the silicon oxide type coating formed by conversion by heating at high temperatures. Colloidal silica is preferred for this finely divided inorganic powder.
A preferred blending ratio between component (A) and colloidal silica is 1 to 100 weight parts of the latter per 100 weight parts of the former. The colloidal silica is preferably used dispersed in an organic solvent with a boiling point less than 200°C. The mixture of component (A) and organic solvent-dispersed colloidal silica must have a viscosity suitable for the execution of a thin coating on the surface of the inorganic base material.

As long as a uniform coating can be formed, there are no particular limitations in the present invention on the procedure by which the coating comprising the organohydrogensiloxane-hydrogensiloxane copolymer represented by siloxane unit formula (1) is formed on the surface of the inorganic base material. The following methods are specific examples of this procedure. (1-1) The organohydrogensiloxane-hydrogensiloxane copolymer that is solid at ambient temperature is liquefied by heating and coated on the surface of the inorganic base material by spin coating, spraying, brushing, dripping, or another technique; (1-2) The organohydrogensiloxane·hydrogensiloxane copolymer that is liquid at ambient temperature is coated on the surface of the inorganic base material by spin coating, spraying, brushing, dripping, or another technique, or an organic solvent solution of the organohydrogensiloxane·hydrogensiloxane copolymer is coated on the surface of the inorganic base material by spin coating, spraying, brushing, dripping, or another technique; or (1-3) The inorganic base material is immersed in and removed from an organic solvent solution of the organohydrogensiloxane·hydrogensiloxane copolymer, or, when the organohydrogensiloxane·hydrogensiloxane copolymer is a solid at ambient temperature, the inorganic base material is immersed in and removed from the organohydrogensiloxane·hydrogensiloxane copolymer that has been liquefied by heating, or, when the organohydrogensiloxane·hydrogensiloxane copolymer is a liquid at ambient temperature, the inorganic base material is immersed in and removed from the organohydrogensiloxane·hydrogensiloxane copolymer itself, (2) Then, as required the organic solvent is removed by, for example, standing, blowing with hot air, heating in a forced convection oven.

### The thickness of the coating comprising the

organohydrogensiloxane·hydrogensiloxane copolymer represented by siloxane unit formula (1) is not particularly limited, as long as it is at least a thickness sufficient to planarize, once conversion to the ceramic silicon oxide type coating by heating at high temperatures has been carried out, asperities or step heights on the surface of the inorganic base material. Among inorganic base materials, the depth (difference between the highest point and the deepest point) of microscopic asperities on the surface of an inorganic base material is generally from 10 nm to 100 nm or from 100 nm to 1 µm, which requires that the thickness of the coating under consideration be larger than this. However, depending on the type of inorganic substrate, the depth (difference between the highest point and the deepest point) of microscopic asperities on the surface is from several hundred nanometers to several micrometers (for example, 200 nm to 3 µm), which requires that the thickness of the coating under consideration be larger than this. Considering electronic devices within the range of inorganic base materials, and particularly semiconductor devices, liquid crystal devices or printed wiring boards, the step height on these surfaces is typically from several hundred nanometers to several micrometers (for example, 500 nm to 6 µm), which requires that the thickness of the coating under consideration be larger than this.

The ceramic silicon oxide type coating that can be obtained by conversion of the organohydrogensiloxane-hydrogensiloxane copolymer represented by siloxane unit formula (1) by heating at high temperatures, because it is characterized by being more resistant to cracking than the silicon oxide type coatings from the heretofore known hydrogensilsesquioxane resins, can form a coating without cracking even at a coating thickness of 1 µm and above, 1.5 µm and above, or 2 µm and above. The upper limit on the thickness of this coating is not critical; however, the upper limit must be no greater than the thickness that can be formed on the surface of the inorganic base material, and is up to a thickness at which there is no waste of the materials and there are no detrimental effects with regard to performance once conversion into the ceramic silicon oxide type coating has been carried out by heating at high temperatures (for example, up to 10 µm).

The inorganic base material for formation of the silicon oxide type coating must be capable of withstanding the temperatures that occur when conversion into the silicon oxide type coating is carried out by heating the organohydrogensiloxane·hydrogensiloxane copolymer represented by siloxane unit formula (1).
It must therefore have a heat resistance of at least 350°C, preferably more than 600°C, and more preferably of at least 700°C. In addition, this inorganic base material must have a mechanical strength and durability capable of withstanding stresses and displacements encountered during surface processing and use.

Representative examples of the inorganic base material are inorganic substrates such as metal substrates, ceramic substrates, glass substrates, and quartz substrates, and electronic devices. These inorganic substrates, e.g., metal substrates, ceramic substrates, glass substrates, and quartz substrates, may be thick and lack flexibility or may be thin and possess flexibility, and may constitute a portion of an electronic component or an electronic device or instrument. However, a thin and flexible inorganic substrate is required for use in semiconductor elements and devices such as thin film solar batteries, thin film transistors (TFTs) for reflection-type liquid crystal displays, and thin film electroluminescent display elements and devices.

The electronic device can be exemplified by semiconductor devices, printed wiring boards, bare boards for printed wiring board applications, and liquid crystal devices. The semiconductor devices can be exemplified by discrete semiconductor elements such as transistors, field-effect transistors (FETs), thyristors (SCRs), diodes (rectifiers), light-emitting diodes (LEDs), as well as by monolithic integrated circuits (monolithic ICs), hybrid integrated circuits, and intermediates in the fabrication of the preceding (for example, a semiconductor substrate having circuitry formed on its surface). The printed wiring boards can be exemplified by single-sided wiring boards, two-sided wiring boards, multilayer wiring boards, and intermediates in the fabrication of the preceding (for example, a bare board having printed wirings formed on its surface). The liquid crystal devices can be exemplified by glass substrates for liquid crystal applications and metal foils for liquid crystal applications.

The inorganic substrate is preferably a metal substrate (for example, a thin metal plate or metal foil) when considered from the perspective of mechanical strength. The metal can be specifically exemplified by gold, silver, copper, nickel, titanium, titanium alloys, aluminum, duralumin, and steel and particularly by stainless steel and molybdenum steel. The stainless steel foil can be exemplified by ferritic stainless steel foil, martensitic stainless steel foil, and austenitic stainless steel foil. Stainless steel foil is preferred among the preceding from the perspectives of heat resistance and flexibility.
When viewed from the perspective of transparency, the inorganic substrate is preferably a glass substrate or quartz substrate. A ceramic substrate (for example, an alumina substrate) is preferred from the perspective of electrical insulation, moldability, and mechanical strength.

The thin plate encompassed by the inorganic substrate has a thickness preferably of at least 10 µm but less than 1 mm and more preferably of at least 20 µm but less than 100 µm. A more flexible substrate with a higher bendability is obtained as the thickness of the thin plate diminishes. However, at thicknesses of less than 10 µm, the problem arises of a loss of handling properties due to the high flexibility. Little flexibility is present at above 100 µm and particularly at above 1 mm. A thin plate outside the range given above is unsuitable as a substrate for thin film semiconductor devices such as thin film solar batteries. Asperities occur on the surface of the inorganic substrate under consideration, and the method of the present invention for forming a ceramic silicon oxide type coating and the method of the present invention for producing an inorganic base material having a silicon oxide type coating, can reduce the surface roughness of an inorganic substrate that exhibits these asperities and can planarize a surface on which asperities occur.

The inorganic base material bearing the coating of the above-described organohydrogensiloxane-hydrogensiloxane copolymer represented by siloxane unit formula (1) is then heated at high temperatures in an inert gas or in an oxygen gas-containing inert gas (oxygen gas less than 20 volume%), thereby converting the coated copolymer to a ceramic silicon oxide type coating.
Due to the presence of the organohydrogensiloxane unit in the organohydrogensiloxane-hydrogensiloxane copolymer represented by siloxane unit formula (1), this copolymer can be converted into a ceramic silicon oxide type material n which the crosslink density is well controlled and internal stresses are thoroughly relaxed. This enables the formation of a crack- and pinhole-free ceramic silicon oxide type coating even at film thicknesses of 1 µm and above and particularly at film thicknesses of 2 µm and above.

The inert gas is preferably a gas that is inert with respect to the ceramic silicon oxide type coating and the organohydrogensiloxane·hydrogensiloxane copolymer represented by siloxane unit formula (1) during the process in which said copolymer is converted into the silicon oxide type coating. Such an inert gas can be specifically exemplified by nitrogen, argon, and helium. The inert gas may contain oxygen gas, but the oxygen gas concentration must be less than 20 volume%. Cracks and pinholes tend to be produced in the silicon oxide type coating at above 20 volume%. From such point of view, the oxygen gas concentration is preferably less than 0.5 volume%.

As long as conversion of the copolymer into ceramic silicon oxide can be effected, there are no particular limitations on the temperature or time for heating the inorganic base material bearing the coating of the organohydrogensiloxane·hydrogensiloxane copolymer represented by siloxane unit formula (1). When, however, the copolymer is in the form of an organic solvent solution, heating, for example, for 10 to 30 minutes at a temperature from room temperature to 200°C is preferably carried out first in order to evaporate the organic solvent. This is followed by heating preferably for at least 30 minutes at 300 to 600°C in an inert gas atmosphere or an atmosphere of inert gas that contains oxygen gas (oxygen gas less than 20 volume%). In particular, heating at 350 to 550°C is more desirable.

The oxidation reaction and dehydrogenative condensation reaction of the silicon-bonded hydrogen atoms can each advance stepwise since the oxidation reaction rate of the silicon-bonded hydrogen in the (HRSiO_{2/2}) unit in the organohydrogensiloxane·hydrogensiloxane copolymer represented by the siloxane unit formula (1) (HRSiO_{2/2})ₙ(HSiO_{3/2})ₘ is slower than the oxidation reaction rate of the silicon-bonded hydrogen in the (HSiO_{3/2}) unit.
A larger HRSiO_{2/2} unit content results in a lower polysiloxane chain crosslink density in the cured stage and prevents the crosslinking reaction from occurring rapidly, thereby enabling the generation of internal stresses to be stopped or relaxed. That is, at a larger HRSiO_{2/2} unit content, the process of crosslinking and curing by formation of the SiOSi bond proceeds more gradually and the generation of cracks is inhibited.

At this point, the thorough conversion of the copolymer coating into the ceramic silicon oxide type coating is preferably confirmed. For example, confirmation can be obtained by measuring, using an infrared spectrophotometer, the content of the SiH group (sharp, strong absorption peaks assigned to the SiH group at 910 cm⁻¹ and 2150 cm⁻¹), the silanol group (broad, medium strength absorption peak assigned to the silanol group at around 3500 cm⁻¹), and, depending on the circumstances, also the alkoxy group (sharp, weak absorption peak assigned to the alkoxy group at 2870 cm⁻¹) in the coating of the organohydrogensiloxane·hydrogensiloxane copolymer represented by siloxane unit formula (1) formed on the surface of the inorganic base material; then measuring these in the ceramic silicon oxide type coating after high-temperature heating; and comparing the measurements.
A thorough conversion into the ceramic silicon oxide type coating can also be confirmed from the fact that, when after heating the ceramic silicon oxide type coating is immersed in an organic solvent that strongly dissolves the organohydrogensiloxane·hydrogensiloxane copolymer represented by siloxane unit formula (1), the ceramic silicon oxide type coating is insoluble in this organic solvent.

The method of the present invention for forming a ceramic silicon oxide type coating and the method of the present invention for producing an inorganic base material that has a ceramic silicon oxide type coating, can form a planar ceramic silicon oxide type coating without producing cracks or pinholes. The ceramic silicon oxide type coating is hard and has a pencil hardness according to 8.4.2 of JIS K 5400 of 2H to 9H, preferably 4H to 9H, and more preferably 7H to 9H.

The thickness of the ceramic silicon oxide type coating formed by conversion of the organohydrogensiloxane·hydrogensiloxane copolymer represented by siloxane unit formula (1) by heating at high temperatures, is not particularly limited as long as it is at least a thickness sufficient to planarize asperities and step heights on the surface of the inorganic base material. Among inorganic base materials, the depth (difference between the highest point and the deepest point) of microscopic asperities on the surface of an inorganic substrate can typically be from 10 nm to 100 nm or from 100 nm to 1 µm, which requires that the thickness of the coating under consideration be larger than this. However, depending on the type of inorganic substrate, the depth (difference between the highest point and the deepest point) of microscopic asperities on the surface can be from several hundred nanometers to several micrometers (for example, 200 nm to 3 µm), which requires that the thickness of the coating under consideration be larger than this.

Considering electronic devices within the range of inorganic base materials, and particularly semiconductor devices, liquid crystal devices, printed wiring boards, the step height on these surfaces is typically from several hundred nanometers to several micrometers (for example, 500 nm to 6 µm), which requires that the thickness of the coating under consideration be larger than this.
The ceramic silicon oxide type coating that can be obtained by conversion of the organohydrogensiloxane-hydrogensiloxane copolymer represented by siloxane unit formula (1) by heating at high temperatures, because it is characterized by being more resistant to cracking than the silicon oxide type coatings from the heretofore known hydrogensilsesquioxane resins, can form a coating without cracking even at a coating thickness of 1 µm and above, 1.5 µm and above, or 2 µm and above. The upper limit on the thickness of this coating is not critical; however, the upper limit must be no greater than the thickness that can be formed on the surface of the inorganic base material and is up to a thickness at which there is no waste of the materials and there are no detrimental effects with respect to performance (for example, up to 10 µm).

Moreover, the method of the present invention for forming a ceramic silicon oxide type coating and the method of the present invention for producing an inorganic base material that has a ceramic silicon oxide type coating, are able to form a ceramic silicon oxide type coating at temperatures lower than the melting point of aluminum (660°C) and are thus able to avoid melting aluminum, which is in wide use for circuit wirings of semiconductor devices.
These methods are therefore useful for the formation of interlayer dielectric films and for the formation of passivation films on the surface of a semiconductor device. They are also useful for the formation of interlayer dielectric films in a multilayer semiconductor device because a ceramic silicon oxide type coating or organic resin coating can be additionally formed on the surface of the obtained inorganic base material bearing a ceramic silicon oxide type coating.

The inorganic substrate bearing the ceramic silicon oxide type coating that is the conversion product from the organohydrogensiloxane·hydrogensiloxane copolymer represented by siloxane unit formula (1), because it is planarized by this ceramic silicon oxide type coating and because the ceramic silicon oxide type coating itself exhibits the combination of an excellent heat resistance, excellent cold resistance, excellent electrical insulation performance, excellent mechanical strength and excellent chemical resistance, is useful as a substrate for the production of solar batteries, reflection-type liquid crystal displays or electroluminescent display devices.
When the inorganic substrate is a thin and flexible metal plate, the inorganic substrate bearing the ceramic silicon oxide type coating that is the conversion product from the organohydrogensiloxane·hydrogensiloxane copolymer represented by siloxane unit formula (1), is useful as a substrate for the electrodes of thin film solar batteries, thin film transistors (TFTs) for reflection-type liquid crystal displays, thin film electroluminescent display elements and devices, and thin film lithium batteries. When the inorganic substrate is a thin glass plate, the inorganic substrate bearing the ceramic silicon oxide type coating that is the conversion product from the organohydrogensiloxane-hydrogensiloxane copolymer represented by siloxane unit formula (1), is useful as an inorganic substrate for the production of thin film solar batteries, thin film transistors (TFTs) for transmission-type liquid crystal displays or thin film electroluminescent display elements and devices.

For example, a thin film solar battery can be fabricated by forming a first electrode thin film on the surface of a thin and flexible metal plate that has a ceramic silicon oxide type coating that is the conversion product from the organohydrogensiloxane·hydrogensiloxane copolymer represented by siloxane unit formula (1); forming a silicon semiconductor thin film on the first electrode thin film; and then forming a second electrode thin film on the silicon semiconductor thin film.
Or, a thin film solar battery can be fabricated by forming a first electrode thin film on the surface of a ceramic silicon oxide type coating that is the conversion product from the organohydrogensiloxane·hydrogensiloxane copolymer represented by siloxane unit formula (1); forming a compound semiconductor thin film on the first electrode thin film; and then subjecting the compound semiconductor thin film to heat treatment.

A thin film transistor can be fabricated by forming an amorphous silicon semiconductor thin film on the surface of a thin and flexible metal plate that has a ceramic silicon oxide type coating that is the conversion product from the organohydrogensiloxane-hydrogensiloxane copolymer represented by siloxane unit formula (1), followed by heat treatment.

A thin film electroluminescent (EL) element can be fabricated, for example, by forming a silicon-containing electroconductive electrode layer on the surface of a thin and flexible metal plate that has a ceramic silicon oxide type coating that is the conversion product from the organohydrogensiloxane-hydrogensiloxane copolymer represented by siloxane unit formula (1); forming an electrical insulation layer on the silicon-containing electroconductive transparent layer; forming a light-emitting layer on the electrical insulation layer; and then heat treating.

The positive electrode material of a lithium battery can be fabricated by forming a positive electrode layer, for example, a manganese oxide thin film, LiMn₂O₄, and so forth, on the surface of a thin and flexible metal plate that has a ceramic silicon oxide type coating that is the conversion product from the organohydrogensiloxane-hydrogensiloxane copolymer represented by siloxane unit formula (1).
Processes such as high-temperature vapor deposition, plasma CVD, sputtering, high-temperature heat treatment, are carried out during the fabrication of the preceding, and as a result the thin and flexible metal plate is exposed to very high temperatures, for example, 400 to 700°C. However, the thin and flexible metal plate does not undergo alteration, deterioration, or distortion because it carries the ceramic silicon oxide type coating that is the conversion product from the organohydrogensiloxane·hydrogensiloxane copolymer represented by siloxane unit formula (1).

A thin film solar battery, which is a representative example of a thin film semiconductor device, is typically fabricated through a process that comprises, for example, the following in the sequence given: first, deposition of a metal layer, such as molybdenum, on a thin metal plate and then formation of a thin film electrode layer by a means such as, for example, photoetching; deposition of a semiconductor layer and then formation of a thin film semiconductor layer by a means such as, for example, photoetching or laser scribing; and deposition of a transparent electroconductive film on the preceding thin film semiconductor layer and then formation of a thin film electrode layer by a means such as, for example, photoetching.
As a consequence, the thin metal plate must exhibit chemical resistance and corrosion resistance. Since thin film solar batteries are used in applications that require flexibility, the thin metal plate must be flexible, and, for example, stainless steel, molybdenum copper or alumina, in particular are suitable from the standpoints of thermal conductivity, chemical resistance, and corrosion resistance. In addition to having these properties, thin stainless steel plate, that is, stainless steel foil, is particularly preferred from the standpoints of availability for acquisition and economics. This stainless steel foil can be exemplified by ferritic stainless steel foil, martensitic stainless steel foil, and austenitic stainless steel foil. A very suitable substrate is therefore stainless steel foil having a ceramic silicon oxide type coating that is the conversion product from the organohydrogensiloxane-hydrogensiloxane copolymer represented by siloxane unit formula (1).

The type of metal in the metal electrode formed on the ceramic silicon oxide type coating that is the conversion product from the organohydrogensiloxane-hydrogensiloxane copolymer represented by siloxane unit formula (1), is not particularly limited and can be exemplified by molybdenum, aluminum, gold, silver, copper, iron or tin, as well as alloys of each metal.
The semiconductor in the semiconductor layer formed on this metal electrode can be exemplified by polycrystalline silicon semiconductors, monocrystalline silicon semiconductors, amorphous silicon semiconductors, and compound semiconductors. The compound semiconductors can be exemplified by CIS, CdTe, and GICS. The transparent electrode formed on this semiconductor layer can be exemplified by indium-tin oxide alloy, tin oxide, indium oxide, and zinc oxide. A protective layer can optionally also be formed on the transparent electrode; this protective layer is suitably a polymeric material that exhibits a high light transmittance and an excellent resistance to weathering, such as a fluororesin or transparent polyimide.

With regard to a thin film solar battery obtained in this manner, the substrate therein is flexible and bendable and will not undergo cracking during production or handling, while the ceramic silicon oxide type coating that is the conversion product from the organohydrogensiloxane·hydrogensiloxane copolymer represented by siloxane unit formula (1), will not undergo cracking or separation from the stainless steel foil. As a consequence, a thin film solar battery obtained in this manner exhibits an excellent productivity, excellent handling characteristics, an excellent durability.
The same applies not only to thin film solar batteries, but also to thin film semiconductor devices such as thin film transistors (TFTs) for reflection-type liquid crystal display devices, thin film electroluminescent display elements and devices or thin film lithium batteries.

### Examples

The present invention is described in greater detail in the reference examples, examples, and comparative examples. The organohydrogensiloxane-hydrogensiloxane copolymer represented by siloxane unit formula (1) that was used in the examples of the present invention and the comparative examples was produced by the methods described in the reference examples below, but its method of synthesis is not limited to the methods described in the following reference examples.

The properties cited in the reference examples, practical examples, and comparative examples were measured using the conditions described below.

### [Viscosity]

The viscosity of the methylhydrogensiloxane · hydrogensiloxane copolymer and the phenylhydrogensiloxane · hydrogensiloxane copolymer was measured at 25°C using an E-type rotary viscometer (TOKIMEC INC).

### [Weight-average molecular weight and molecular weight distribution]

The weight-average molecular weight and molecular weight distribution of the methylhydrogensiloxane · hydrogensiloxane copolymer and the phenylhydrogensiloxane · hydrogensiloxane copolymer were measured by gel permeation chromatography (GPC). The instrumentation used for this was an HLC-8020 gel permeation chromatograph (GPC) (Tosoh Corporation) equipped with a refractive index detector and two TSKgel GMHXL-L columns (Tosoh Corporation). The sample was submitted to the measurement in the form of the 2 mass% chloroform solution. The working curve was constructed using polystyrene standards of known molecular weight. The weight-average molecular weight was thus determined on a polystyrene standard basis.

### [²⁹Si-NMR and ¹H-NMR]

The ²⁹Si-NMR and ¹H-NMR of the methylhydrogensiloxane · hydrogensiloxane copolymer and the phenylhydrogensiloxane · hydrogensiloxane copolymer were measured using a Bruker ACP-300 Spectrometer.

The surface roughness of the ceramic silicon oxide type coating, stainless steel foil, and thin glass plate was determined using a 25 µm scan with an AFM-DI5000 Atomic Force Microscope (abbreviated as AFM). The thickness of the ceramic silicon oxide type coating was determined by measuring its cross section with an FESEM-JEOL JSM-6335F Field Emission Scanning Electron Microscope. Cracking of the ceramic silicon oxide type coating was observed with a KEYENCE VH-7000 electron microscope.

### Reference Example 1

1.0 g sodium octylsulfonate, 200 mL toluene, and 200 mL concentrated hydrochloric acid were introduced into a four-neck flask equipped with a stirrer, thermometer, nitrogen gas inlet, and dropping funnel. Then, while stirring at -25 to -30°C and injecting a nitrogen gas flow, a liquid mixture of 4.7 g (0.040 mol) methylhydrogendichlorosilane and 12.5 g (0.093 mol) hydrogentrichlorosilane (methylhydrogendichlorosilane : hydrogentrichlorosilane molar ratio = 0.30 : 0.70) was added dropwise over 60 minutes from the dropping funnel.
Stirring at room temperature was continued for 1 hour after the completion of addition, after which the organic layer was isolated using a separatory funnel, washed with water to neutrality, and dried over anhydrous magnesium sulfate powder. The anhydrous magnesium sulfate powder was then filtered off; the toluene was removed by heating under reduced pressure using a rotary evaporator; and the residue was dried in a vacuum.

The dried residue was a colorless, transparent liquid; the yield was 65%; and the molecular weight distribution presented a plurality of peaks. Its viscosity was 25,000 mPa · s; the weight-average molecular weight (Mw) was 27.5 × 10³; and the average siloxane unit formula of the methylhydrogensiloxane · hydrogensiloxane copolymer, as determined from the integrated values in the ²⁹Si-NMR of the signal at -32.4 ppm assigned to the HMeSiO_{2/2} unit and the signal at -84.9 ppm assigned to the HSiO_{3/2} unit or the integrated values in the ¹H-NMR of the signal at 4.71 ppm assigned to the HMeSiO_{2/2} unit and the signal at 4.3 ppm assigned to the HSiO_{3/2} unit, was (HMeSiO_{2/2})_{0.28}(SiO_{3/2})_{0.72}.

### Reference Example 2

A colorless, transparent solid was obtained using the same procedure as in Reference Example 1, but in this case using a mixture of 2.20 g (0.012 mol) hydrogenphenyldichlorosilane and 15.0 g (0.085 mol) hydrogentrichlorosilane (hydrogenphenyldichlorosilane : hydrogentrichlorosilane molar ratio = 12 : 88) rather than the mixed liquid of methylhydrogendichlorosilane and hydrogentrichlorosilane that was used in Reference Example 1. The yield was 65%; the weight-average molecular weight (Mw) was 19,100; and the average siloxane unit formula of the phenylhydrogensiloxane · hydrogensiloxane copolymer, as determined from the integrated values in the ²⁹Si-NMR of the signal at -50.4 ppm assigned to the HPhSiO_{2/2} unit and the signal at -84.9 ppm assigned to the HSiO_{3/2} unit or the integrated values in the ¹H-NMR of the signal at 5.1 ppm assigned to the HMeSiO_{2/2} unit and the signal at 4.3 ppm assigned to the HSiO_{3/2} unit, was (HPhSiO_{2/2})_{0.11} (HSiO_{3/2})_{0.89}.

### Practical Example 1

A liquid coating-forming agent (solids concentration = 20 mass%) comprising toluene and the liquid methylhydrogensiloxane · hydrogensiloxane copolymer obtained in Reference Example 1 was coated by spin coating on a thin stainless steel plate, i.e., stainless steel foil (cut to 150 mm square), that was 24 µm thick and had a surface roughness Rmax of 56.7 nm, followed by heating for 2 hours at 200°C. The resulting copolymer-coated stainless steel foil was introduced into an open cylindrical annular furnace and heated for 1 hour at 400°C under a nitrogen gas current (oxygen gas concentration = 50 ppm) and subsequently taken out. The stainless steel foil having a ceramic silicon oxide type coating was then gradually cooled to room temperature in a nitrogen gas atmosphere.

Measurement of the properties of the ceramic silicon oxide type coating formed on the stainless steel foil gave a maximum thickness of 2.39 µm, while AFM inspection of the roughness of the surface of the ceramic silicon oxide type coating gave an Rmax of 1.0 nm. The asperities on the surface of this stainless steel foil had been uniformly planarized. Microscopic inspection confirmed that cracks and pinholes were not present in this ceramic silicon oxide type coating.
Structural analysis by transmission-mode Fourier transform infrared spectroscopy confirmed that the SiH group peaks (910 cm⁻¹ and 2150 cm⁻¹) and the silanol group peak (around 3500 cm⁻¹) were entirely absent from the ceramic silicon oxide type coating. In addition, it was found that the obtained ceramic silicon oxide type coating was insoluble in organic solvents such as MIBK and acetone.

### Practical Example 2

A liquid coating-forming agent (solids concentration = 20 mass%) comprising toluene and the phenylhydrogensiloxane · hydrogensiloxane copolymer obtained in Reference Example 2 was coated by spin coating on the same type of stainless steel foil as the stainless steel foil used in Example 1 and was then heated for 2 hours at 200°C. The resulting copolymer-coated stainless steel foil was introduced into an open cylindrical annular furnace and heated for 1 hour at 450°C under a nitrogen gas current (oxygen gas concentration = 10 ppm). The stainless steel foil having a ceramic silicon oxide type coating was then gradually cooled to room temperature in a nitrogen gas atmosphere.

Measurement of the properties of the ceramic silicon oxide type coating formed on the stainless steel foil gave a maximum thickness of 2.8 µm, while AFM inspection of the roughness of the surface of the ceramic silicon oxide type coating gave an Rmax of 1.0 nm. The asperities on the surface of this stainless steel foil had been uniformly planarized. Microscopic inspection confirmed that cracks and pinholes were not present in this ceramic silicon oxide type coating. Structural analysis by transmission-mode Fourier transform infrared spectroscopy confirmed that the SiH group peaks (910 cm⁻¹ and 2150 cm⁻¹) and the silanol group peak (around 3500 cm⁻¹) were entirely absent from the ceramic silicon oxide type coating. In addition, it was found that the obtained ceramic silicon oxide type coating was insoluble in organic solvents such as MIBK and acetone.

### Practical Example 3

The phenylhydrogensiloxane · hydrogensiloxane copolymer obtained in Reference Example 2 was diluted with toluene to give a solids concentration of 20 mass% and was dip coated onto a thin glass plate that had a surface roughness Rmax of 30.6 nm and a thickness of 75 µm; this was followed by heating for 2 hours at 200°C.
The resulting copolymer-coated thin glass plate was introduced into an open cylindrical annular furnace and heated for 1 hour at 450°C under a nitrogen gas current (oxygen gas concentration = 50 ppm). The thin glass plate having a ceramic silicon oxide type coating was then gradually cooled to room temperature in a nitrogen gas atmosphere.

Measurement of the properties of the ceramic silicon oxide type coating formed on the this thin glass plate gave a maximum thickness of 2.5 µm, while AFM inspection of the roughness of the surface of the ceramic silicon oxide type coating gave an Rmax of 1.0 nm. The asperities on the surface of this thin glass plate had been uniformly planarized. Microscopic inspection confirmed that cracks and pinholes were not present in this ceramic silicon oxide type coating. Structural analysis by transmission-mode Fourier transform infrared spectroscopy confirmed that the SiH group peaks (910 cm⁻¹ and 2150 cm⁻¹) and the silanol group peak (around 3500 cm⁻¹) were entirely absent from the ceramic silicon oxide type coating. In addition, it was found that the obtained ceramic silicon oxide type coating was insoluble in organic solvents such as MIBK and acetone.

### Practical Example 4

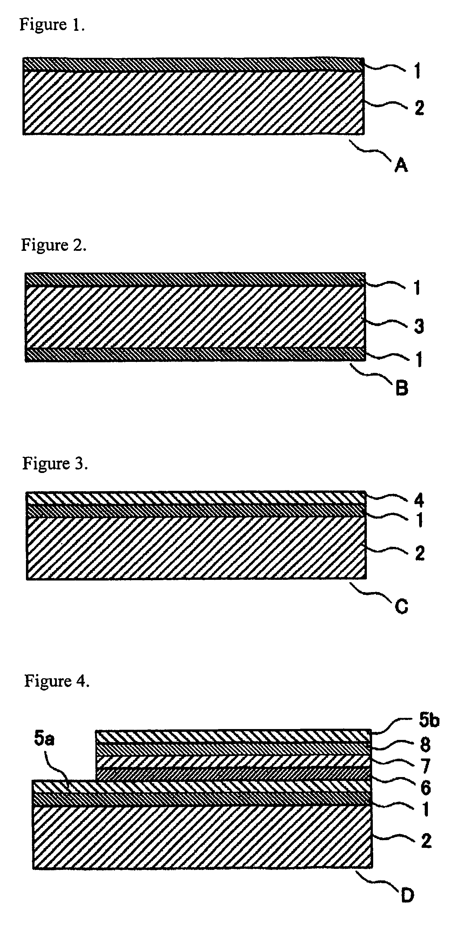

Thin film compound semiconductor solar battery cells having the cross section shown in Figure 4 were fabricated by vapor-depositing an Mo back-side electrode thin layer, a CIGS-type light-absorbing thin layer comprising CuInGaSe₂, a high-resistance CdS buffer thin layer, a ZnO semi-insulating thin layer, and an ITO transparent electrode thin layer by known methods in the sequence given on the ceramic silicon oxide type coating of the ceramic silicon oxide type coating-bearing stainless steel foil obtained in Example 1 and on the ceramic silicon oxide type coating of the ceramic silicon oxide type coating-bearing stainless steel foil obtained in Example 2. These thin film solar battery cells exhibited high photoconversion efficiencies.

### Comparative Example 1

An inorganic SOG (trade name: OCD-typeII) from Tokyo Ohka Kogyo Co., Ltd., was spin coated on the same type of stainless steel foil as the stainless steel foil used in Example 1 to form an inorganic SOG coating having a maximum thickness of 0.55 µm. The resulting inorganic SOG-coated stainless steel foil was introduced into an open cylindrical annular furnace and heated for 1 hour at 400°C in air. Gradual cooling to room temperature was then carried out in air.
When the attempt was made to measure the properties of the silicon oxide type coating formed on the stainless steel foil, cracks visible to the naked eye were present in large numbers and the film thickness could not be measured.

### Comparative Example 2

In accordance with the reference example in JP H11-106658 A, hydrogentriethoxysilane was dissolved in ethanol, and, while stirring this with ice water cooling, sufficient water was added dropwise to provide 3 gram-equivalents water per gram-equivalent hydrogentriethoxysilane. Stirring was continued at room temperature after the completion of addition, after which the precipitate was filtered off and the ethanol was removed; drying in a vacuum then yielded a hydrogenpolysilsesquioxane resin. A 30 mass% solution was prepared by dissolving this hydrogenpolysilsesquioxane resin, in a quantity sufficient to give a solids concentration of 30 mass%, in methyl isobutyl ketone that had been dried over molecular sieve.

This solution was spin coated on stainless steel foil of the same type as the stainless steel foil used in Example 1 to form a hydrogenpolysilsesquioxane resin coating having a maximum thickness of 1.15 µm.
The resulting hydrogenpolysilsesquioxane resin-coated stainless steel foil was introduced into an open cylindrical annular furnace and heated for 1 hour at 400°C in air. The stainless steel foil was then removed and gradually cooled to room temperature in air. The maximum thickness of the silicon oxide type coating formed on the stainless steel foil was 0.98 µm; however, microscopic inspection confirmed that microcracks had been generated in large numbers in this silicon oxide type coating.

### Comparative Example 3

The toluene solution of methylhydrogensiloxane · hydrogensiloxane copolymer prepared in Example 1 was spin coated on stainless steel foil of the same type as the stainless steel foil used in Example 1, resulting in the formation of a methylhydrogensiloxane · hydrogensiloxane copolymer coating with a maximum thickness of 2.30 µm on the surface of the stainless steel foil. The resulting copolymer-coated stainless steel foil was introduced into an open cylindrical annular furnace and heated for 1 hour at 400°C in air.
The stainless steel foil was then removed and gradually cooled to room temperature in air. The maximum thickness of the silicon oxide type coating formed on the stainless steel foil was 2.10 µm; however, microscopic inspection confirmed that microcracks had been generated in large numbers in this silicon oxide type coating.

### Industrial Applicability

The method of the present invention for forming a ceramic silicon oxide type coating is useful for forming a ceramic silicon oxide type coating that is free of cracking and pinholes and that is capable of planarizing asperities and step heights on an inorganic base material. The method of the present invention for producing an inorganic base material having a ceramic silicon oxide type coating is useful for producing an inorganic substrate for electronic devices and particularly semiconductor devices, such as solar batteries, reflection-type liquid crystal displays, or electroluminescent display elements; in particular is useful for producing an inorganic substrate for thin film semiconductor devices such as thin film solar batteries, thin film transistors for reflection-type liquid crystal displays, or thin film electroluminescent display elements; and is useful for producing an inorganic substrate for forming the electrodes of thin film lithium batteries.
The agent of the present invention for forming a ceramic silicon oxide type coating is useful for planarizing asperities and step heights on the surface of an inorganic base material and is useful for the formation of a crack- and pinhole-free ceramic silicon oxide type coating on an inorganic base material. Specifically, this agent is useful for the electrical insulating coatings of electronic devices, for the planarizing films of electronic devices, for the passivation films of electronic devices, and for the interlayer dielectric films of electronic devices. The semiconductor device of the present invention is useful for solar houses, visual media devices, portable telephones, computers, displays, household electrical appliances, office automation equipment, automobiles, aircraft, satellites, or ships.

## Claims

1. A method of forming a ceramic silicon oxide type coating, comprising forming a coating comprising an organohydrogensiloxane-hydrogensiloxane copolymer represented by siloxane unit formula (1):
(HRSiO₂ₗ₂)ₙ(HSiO_{3/2})ₘ (1)
(in the formula, R is a monovalent hydrocarbyl group selected from the group consisting of C₁₋₁₀ alkyl group and C₆₋₁₀ aryl group, **n** is a number with an average value of 0.01 ≤ **n ≤** 0.80, and **n** + **m** = 1) on the surface of an inorganic base material; and
then heating the coated inorganic base material to a high temperature in an inert gas or an oxygen gas-containing inert gas (oxygen gas less than 20 volume%) to convert the coating into a ceramic silicon oxide type coating.

2. The method of forming a ceramic silicon oxide type coating according to claim 1, wherein the inert gas is nitrogen gas.

3. The method of forming a ceramic silicon oxide type coating according to claim 1 or 2, wherein the heating temperature is 300 to 600°C.

4. A method of producing an inorganic base material having a ceramic silicon oxide type coating on the surface, comprising
forming a coating comprising an organohydrogensiloxane-hydrogensiloxane copolymer represented by siloxane unit formula (1):
(HRSiO_{2/2})ₙ(HSiO_{3/2})ₘ (1)
(in the formula, R is a monovalent hydrocarbyl group selected from the group consisting of C₁₋₁₀ alkyl group and C₆₋₁₀ aryl group, **n** is a number with an average value of 0.01 ≤ **n** ≤ 0.80, and **n** + **m** = 1) on the surface of an inorganic base material; and
then heating the coated inorganic base material to a high temperature in an inert gas or an oxygen gas-containing inert gas (oxygen gas less than 20 volume%) to convert the coating into a ceramic silicon oxide type coating.

5. The method of producing an inorganic base material according to claim 4, wherein the inorganic base material is a metal substrate, ceramic substrate, glass substrate, quartz substrate, or electronic device.

6. The method of producing an inorganic base material according to claim 5, wherein the metal substrate is a thin and flexible metal plate.

7. The method of producing an inorganic base material according to claim 6, wherein the thin and flexible metal plate is a stainless steel foil.

8. An agent for forming a ceramic silicon oxide type coating, that comprises (A) an organohydrogensiloxane-hydrogensiloxane copolymer represented by siloxane unit formula (1)
(HRSiO_{2/2})ₙ(HSiO_{3/2})ₘ (1)
(in the formula, R is a monovalent hydrocarbyl group selected from the group consisting of C₁₋₁₀ alkyl group and C₆₋₁₀ aryl group, **n** is a number with an average value of 0.01 ≤ **n ≤** 0.80, and **n** + **m** = 1), or comprises component (A) and (B) an organic solvent in a quantity required for the dissolution or dilution of component (A), and can be converted into a ceramic silicon oxide type coating by heating to a high temperature in an inert gas or an oxygen gas-containing inert gas (oxygen gas less than 20 volume%).

9. The agent for forming a ceramic silicon oxide type coating according to claim 8, wherein **n** in siloxane unit formula (1) is a number with an average value of 0.05 ≤ **n** ≤ 0.50.

10. The agent for forming a ceramic silicon oxide type coating according to claim 8 or 9, wherein R in siloxane unit formula (1) is methyl, phenyl, or methyl and phenyl.

11. A method for producing a semiconductor device comprising:
forming a coating comprising an
organohydrogensiloxane-hydrogensiloxane copolymer represented by siloxane unit formula (1):
(HRSiO_{2/2})ₙ(HSiO_{3/2})ₘ (1)
(in the formula, R is a monovalent hydrocarbyl group selected from the group consisting of C₁₋₁₀ alkyl group and C₆₋₁₀ aryl group, **n** is a number with an average value of 0.01 ≤ **n** ≤ 0.80, and **n** + **m** = 1) on the surface of a metal substrate; and then heating the coated metal substrate to a high temperature in an inert gas or an oxygen gas-containing inert gas (oxygen gas less than 20 volume%) to convert the coating into a ceramic silicon oxide type coating;
and
then forming a semiconductor layer on the ceramic silicon oxide type coating of the metal substrate.

12. The method according to claim 11, wherein the metal substrate is stainless steel foil; the semiconductor layer is a silicon semiconductor thin layer or a compound semiconductor thin layer; and the semiconductor device is a thin film solar battery.

## Patentansprüche

1. Ein Verfahren zum Ausbilden einer keramischen Beschichtung vom Siliciumoxidtyp, umfassend
das Ausbilden einer Beschichtung, die ein Organowasserstoffsiloxan-Wasserstoffsiloxan-Copolymer, dargestellt durch die Siloxaneinheitsformel (1):
(HRSiO_{2/2})ₙ(HSiO_{3/2})ₘ (1)
(in der Formel steht R für eine einbindige Kohlenwasserstoffgruppe, ausgewählt aus der Gruppe, bestehend aus C₁₋₁₀-Alkylgruppe und C₆₋₁₀-Arylgruppe, **n** ist eine Zahl mit einem durchschnittlichen Wert von 0,01 ≤ **n** ≤ 0,80 und **n** + **m** = 1) enthält, auf der Oberfläche eines anorganischen Basismaterials; und
anschließendes Erwärmen des beschichteten anorganischen Basismaterials auf eine hohe Temperatur in einem Inertgas oder einem sauerstoffgashaltigen Inertgas (Sauerstoffgas weniger als 20 Vol.-%), um die Beschichtung in eine keramische Beschichtung vom Siliciumoxidtyp umzuwandeln.

2. Das Verfahren zum Ausbilden einer keramischen Beschichtung vom Siliciumoxidtyp gemäß Anspruch 1, wobei das Inertgas Stickstoffgas ist.

3. Das Verfahren zum Ausbilden einer keramischen Beschichtung vom Siliciumoxidtyp gemäß Anspruch 1 oder 2, wobei die Erwärmungstemperatur 300 bis 600°C ist.

4. Ein Verfahren zum Herstellen eines anorganischen Basismaterials mit einer keramischen Beschichtung vom Siliciumoxidtyp auf der Oberfläche, umfassend
das Ausbilden einer Beschichtung, die ein Organowasserstoffsiloxan-Wasserstoffsiloxan-Copolymer, dargestellt durch die Siloxaneinheitsformel (1):
(HRSiO_{2/2})ₙ(HSiO_{3/2})ₘ (1)
(in der Formel steht R für eine einbindige Kohlenwasserstoffgruppe, ausgewählt aus der Gruppe, bestehend aus C₁₋₁₀-Alkylgruppe und C₆₋₁₀-Arylgruppe, **n** ist eine Zahl mit einem durchschnittlichen Wert von 0,01 ≤ **n** ≤ 0,80 und **n** + **m** = 1) enthält, auf der Oberfläche eines anorganischen Basismaterials; und
anschließendes Erwärmen des beschichteten anorganischen Basismaterials auf eine hohe Temperatur in einem Inertgas oder einem sauerstoffgashaltigen Inertgas (Sauerstoffgas weniger als 20 Vol.-%), um die Beschichtung in eine keramische Beschichtung vom Siliciumoxidtyp umzuwandeln.

5. Das Verfahren zum Herstellen eines anorganischen Basismaterials gemäß Anspruch 4, wobei das anorganische Basismaterial ein Metallsubstrat, ein keramisches Substrat, ein Glassubstrat, ein Quarzsubstrat oder eine elektronische Vorrichtung ist.

6. Das Verfahren zum Herstellen eines anorganischen Basismaterials gemäß Anspruch 5, wobei das Metallsubstrat eine dünne und flexible Metallplatte ist.

7. Das Verfahren zum Herstellen eines anorganischen Basismaterials gemäß Anspruch 6, wobei die dünne und flexible Metallplatte eine Folie aus rostfreiem Stahl ist.

8. Ein Mittel zum Ausbilden einer keramischen Beschichtung vom Siliciumoxidtyp, das (A) ein Organowasserstoffsiloxan-Wasserstoffsiloxan-Copolymer, dargestellt durch die Siloxaneinheitsformel (1):
(HRSiO_{2/2})ₙ(HSiO_{3/2})ₘ (1)
(in der Formel steht R für eine einbindige Kohlenwasserstoffgruppe, ausgewählt aus der Gruppe, bestehend aus C₁₋₁₀-Alkylgruppe und C₆₋₁₀-Arylgruppe, **n** ist eine Zahl mit einem durchschnittlichen Wert von 0,01 ≤ **n** ≤ 0,80 und **n** + **m** = 1) oder Komponente (A) und (B) ein organisches Lösungsmittel in eine Menge, die für das Auflösen oder das Verdünnen der Komponente (A) erforderlich ist, enthält, und in eine keramische Beschichtung vom Siliciumoxidtyp durch Erwärmen auf eine hohe Temperatur in einem Inertgas oder einem sauerstoffgashaltigen Inertgas (Sauerstoffgas weniger als 20 Vol.-%) umgewandelt werden kann.

9. Das Mittel zum Ausbilden einer keramischen Beschichtung vom Siliciumoxidtyp gemäß Anspruch 8, wobei **n** in der Siloxaneinheitsformel (1) eine Zahl mit einem durchschnittlichen Wert von 0,05 ≤ **n ≤** 0,50 ist.

10. Das Mittel zum Ausbilden einer keramischen Beschichtung vom Siliciumoxidtyp gemäß Anspruch 8 oder 9, wobei R in der Siloxaneinheitsformel (1) Methyl, Phenyl oder Methyl und Phenyl ist.

11. Ein Verfahren zum Herstellen einer Halbleitervorrichtung, umfassend: Ausbilden einer Beschichtung, die ein Organowasserstoffsiloxan-Wasserstoffsiloxan-Copolymer, dargestellt durch die Siloxaneinheitsformel (1):
(HRSiO_{2/2})ₙ(HSiO_{3/2})ₘ (1)
(in der Formel steht R für eine einbindige Kohlenwasserstoffgruppe, ausgewählt aus der Gruppe, bestehend aus C₁₋₁₀-Alkylgruppe und C₆₋₁₀-Arylgruppe, **n** ist eine Zahl mit einem durchschnittlichen Wert von 0,01 ≤ **n** ≤ 0,80 und **n** + **m** = 1) enthält, auf der Oberfläche eines Metallsubstrats;
und
anschließendes Erwärmen des beschichteten Metallsubstrats auf eine hohe Temperatur in einem Inertgas oder einem sauerstoffgashaltigen Inertgas (Sauerstoffgas weniger als 20 Vol.-%), um die Beschichtung in eine keramische Beschichtung vom Siliciumoxidtyp umzuwandeln,
und
anschließendes Ausbilden einer Halbleiterschicht auf der keramischen Beschichtung vom Siliciumoxidtyp auf dem Metallsubstrat.

12. Das Verfahren gemäß Anspruch 11, wobei das Metallsubstrat eine Folie aus rostfreiem Stahl ist, die Halbleiterschicht eine Siliciumhalbleiterdünnschicht oder eine Verbindungshalbleiterdünnschicht ist und die Halbleitervorrichtung eine Dünnschichtsolarzelle ist.

## Revendications

1. Procédé de formation d'un revêtement du type oxyde de silicium céramique, comprenant la formation d'un revêtement comprenant un copolymère d'organohydrogénosiloxane•hydrogénosiloxane représenté par la formule d'unité de siloxane (1) :
(HRSiO_{2/2})ₙ(HSiO_{3/2})ₘ (1)
(dans la formule, R représente un groupe hydrocarbyle monovalent choisi dans le groupe constitué d'un groupe alkyle en C₁ à C₁₀ et d'un groupe aryle en C₆ à C₁₀, n représente un nombre ayant une valeur moyenne de 0,01 ≤ n ≤ 0,80, et n + m = 1) sur la surface d'un matériau de base inorganique ; et
ensuite le chauffage du matériau de base inorganique revêtu à température élevée dans un gaz inerte ou un gaz inerte contenant de l'oxygène gazeux (oxygène gazeux inférieur à 20 % en volume) pour convertir le revêtement en un revêtement du type oxyde de silicium céramique.

2. Procédé de formation d'un revêtement du type oxyde de silicium céramique selon la revendication 1, dans lequel le gaz inerte est de l'azote gazeux.

3. Procédé de formation d'un revêtement du type oxyde de silicium céramique selon la revendication 1 ou 2, dans lequel la température de chauffage est de 300 à 600 °C.

4. Procédé de production d'un matériau de base inorganique présentant un revêtement du type oxyde de silicium céramique en surface, comprenant la formation d'un revêtement comprenant un copolymère d'organohydrogénosiloxane•hydrogénosiloxane représenté par la formule d'unité de siloxane (1) :
(HRSiO_{2/2})ₙ(HSiO_{3/2})ₘ (1)
(dans la formule, R représente un groupe hydrocarbyle monovalent choisi dans le groupe constitué d'un groupe alkyle en C₁ à C₁₀ et d'un groupe aryle en C₆ à C₁₀, n représente un nombre ayant une valeur moyenne de 0,01 ≤ n ≤ 0,80, et n + m = 1) sur la surface d'un matériau de base inorganique ; et
ensuite le chauffage du matériau de base inorganique revêtu à température élevée dans un gaz inerte ou un gaz inerte contenant de l'oxygène gazeux (oxygène gazeux inférieur à 20 % en volume) pour convertir le revêtement en un revêtement du type oxyde de silicium céramique.

5. Procédé de production d'un matériau de base inorganique selon la revendication 4, dans lequel le matériau de base inorganique est un substrat en métal, un substrat en céramique, un substrat en verre, un substrat en quartz ou un dispositif électronique.

6. Procédé de production d'un matériau de base inorganique selon la revendication 5, dans lequel le substrat en métal est une plaque métallique fine et flexible.

7. Procédé de production d'un matériau de base inorganique selon la revendication 6, dans lequel la plaque métallique fine et flexible est une feuille en acier inoxydable.

8. Agent pour la formation d'un revêtement du type oxyde de silicium céramique, qui comprend
(A) un copolymère d'organohydrogénosiloxaneehydrogénosiloxane représenté par la formule d'unité de siloxane (1)
(HRSiO_{2/2})ₙ(HSiO_{3/2})ₘ (1)
(dans la formule, R représente un groupe hydrocarbyle monovalent choisi dans le groupe constitué d'un groupe alkyle en C₁ à C₁₀ et d'un groupe aryle en C₆ à C₁₀, n représente un nombre ayant une valeur moyenne de 0,01 ≤ n ≤ 0,80, et n + m = 1), ou qui comprend le composant (A) et (B) un solvant organique en une quantité nécessaire pour la dissolution ou la dilution du composant (A), et qui peut être converti en un revêtement du type oxyde de silicium céramique par chauffage à température élevée dans un gaz inerte ou un gaz inerte contenant de l'oxygène gazeux (oxygène gazeux inférieur à 20 % en volume).

9. Agent pour la formation d'un revêtement du type oxyde de silicium céramique selon la revendication 8, dans lequel n dans la formule d'unité de siloxane (1) représente un nombre ayant une valeur moyenne de 0.05 ≤ n ≤ 0,50.

10. Agent pour la formation d'un revêtement du type oxyde de silicium céramique selon la revendication 8 ou 9, dans lequel R dans la formule d'unité de siloxane (1) représente un groupe méthyle, phényle, ou méthyle et phényle.

11. Procédé de production d'un dispositif semi-conducteur comprenant :
la formation d'un revêtement comprenant un copolymère d'organohydrogénosiloxane•hydrogénosiloxane représenté par la formule d'unité de siloxane (1) :
(HRSiO_{2/2})ₙ(HSiO_{3/2})ₘ (1)
(dans la formule, R représente un groupe hydrocarbyle monovalent choisi dans le groupe constitué d'un groupe alkyle en C₁ à C₁₀ et d'un groupe aryle en C₆ à C₁₀, n représente un nombre ayant une valeur moyenne de 0,01 ≤ n ≤ 0,80, et n + m = 1) sur la surface d'un substrat en métal ; et
ensuite le chauffage du substrat en métal revêtu à température élevée dans un gaz inerte ou un gaz inerte contenant de l'oxygène gazeux (oxygène gazeux inférieur à 20 % en volume) pour convertir le revêtement en un revêtement du type oxyde de silicium céramique ; et
ensuite la formation d'une couche semi-conductrice sur le revêtement du type oxyde de silicium céramique du substrat en métal.

12. Procédé selon la revendication 11, dans lequel le substrat en métal est une feuille en acier inoxydable ; la couche semi-conductrice est une couche semi-conductrice mince en silicium ou une couche semi-conductrice mince fabriquée à partir d'un composé ; et le dispositif semi-conducteur est une batterie solaire en couche mince.
